Europäisches Patentamt

European Patent Office

Office européen des brevets

(19)

(11) Veröffentlichungsnummer: **0 252 364 B1**

(12) **EUROPÄISCHE PATENTSCHRIFT**

(45) Veröffentlichungstag der Patentschrift: 27.02.91

(51) Int. Cl.⁵: **H03F 1/32**

(21) Anmeldenummer: 87109013.0

(22) Anmeldetag: 23.06.87

(54) **Linearisierungsschaltung für HF-Leistungsverstärker.**

(30) Priorität: 26.06.86 DE 3621435

(43) Veröffentlichungstag der Anmeldung:
13.01.88 Patentblatt 88/02

(45) Bekanntmachung des Hinweises auf die
Patenterteilung:
27.02.91 Patentblatt 91/09

(84) Benannte Vertragsstaaten:
AT BE CH DE ES FR GB GR IT LI NL SE

(56) Entgegenhaltungen:
EP-A- 0 047 825
US-A- 3 675 138
US-A- 3 825 843

REVUE TECHNIQUE THOMSON-CSF, Band 6,
Nr. 2, Juni 1974, Seiten 529-548, Versailles,
FR; C. BREMENSON et al.: "Réseau linéariseur pour tube à onde progressive"

(73) Patentinhaber: **Siemens Aktiengesellschaft
Wittelsbacherplatz 2
D-8000 München 2(DE)**

(72) Erfinder: **Lange, Friedrich, Dr.Ing.
Gröbenbachstrasse 17 b
D-8038 Gröbenzell(DE)**

## Beschreibung

Die Erfindung betrifft eine Linearisierungsschaltung für insbesondere mit Wanderfeldröhren aufgebaute HF-Leistungsverstärker entsprechend dem Oberbegriff des Anspruchs 1.

Leistungsverstärker können häufig aufgrund ihres Aussteuerungsverhaltens nicht bis zur Sättigungsleistung betrieben werden, die maximal nutzbare Ausgangsleistung liegt um einen gewissen Abstand unter der Sättigungsleistung. Bei Leistungsverstärkern für sehr hohe Frequenzen im Bereich einiger GHz wirkt neben der Abhängigkeit der Ausgangsleistung von der Eingangsleistung auch die Aussteuerungsabhängigkeit der elektrischen Länge sehr störend.

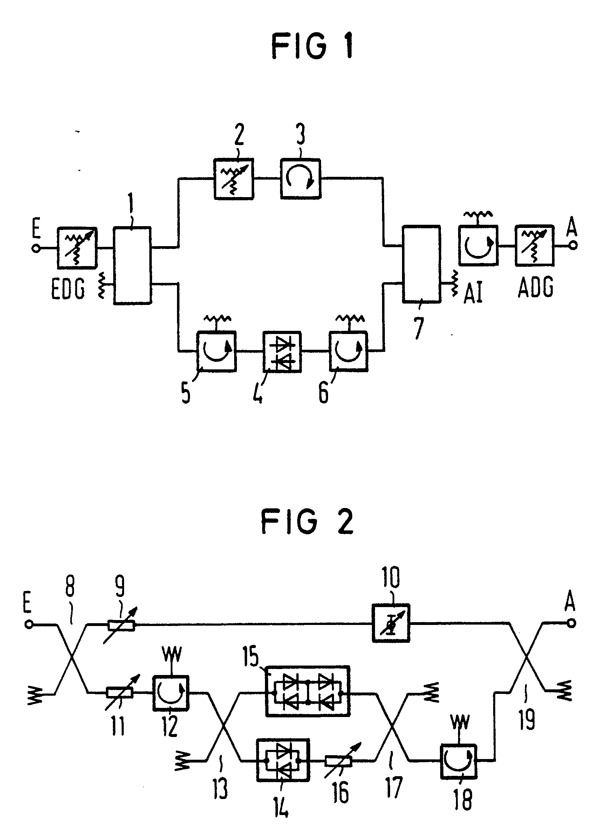

In Revue Technique Thomson-CSF, Vol. 6, No. 2 v. Juni 1974 wird in einer Veröffentlichung von Bremenson und Jaubert "Linearisierungsschaltung für Wanderfeldröhren" eine Möglichkeit beschrieben, einem mit einer Wanderfeldröhre aufgebauten HF-Leistungsverstärker eine Linearisierungsschaltung in Form eines Vorverzerrers vorzuschalten und dadurch die Übertragungseigenschaften für die Kombination zu linearisieren. Die bekannte Linearisierungschaltung ist in der Fig. 1 dargestellt. Die eigentliche Linearisierungsschaltung liegt dabei zwischen zwei variablen Dämpfungsgliedern EDG, ADG, wobei sich an das erste Dämpfungsglied ADG ein Leistungsteiler anschließt, der mittels eines 3 dB 90°-Kopplers aufgebaut ist. Mit einem ersten Ausgang des Leistungsteilers 1 ist über einen, ein Dämpfungsglied 2 und einen Phasenschieber 3 enthaltenden linearen Signalweg ein erster Eingang eines ausgangsseitigen Leistungskombinators 7 verbunden. Mit dem zweiten Ausgang des Leistungsteilers 1, der eine gegenüber dem ersten Ausgang um -90° verschobene Spannung abgibt, ist über einen nichtlinearen Signalweg ein zweiter Eingang des ausgangsseitigen Leistungskombinators 7 verbunden. Der nichtlineare Signalweg enthält zwischen zwei als Isolatoren geschaltete Zirkulatoren 5, 6 einen Expander 4, der aus einem antiparallel geschaltetem Diodenpaar besteht. Der Ausgang des Leistungskombinators 7 ist über einen als Isolator geschalteten Zirkulator Al mit dem ausgangsseitigen Dämpfungsglied ADG verbunden. Die Übertragungseigenschaften der Linearisierungsschaltung nach Fig. 1 können mittels des Phasenschiebers 3 im linearen Weg eingestellt werden. Es muß dabei ein Kompromiß gefunden werden, zwischen optimaler Linearisierung des Amplitudenverhaltens einerseits und möglichst geringer aussteuerungsabhängiger Änderung der elektrischen Länge andererseits, so daß auch weiterhin die Kettenschaltung aus Linearisierungsschaltung und Leistungsverstärker bei kleinen Aussteuerungen bereits nichtlineare Störungen erzeugt.

Aus der DE-A-23 52 569 ist in Verbindung mit Wanderfeldröhrenverstärkern eine Phasenkorrekturanordnung bekannt, die ebenfalls einen linearen und einen nicht linearen Signalweg und eine Addieranordnung für die Ausgangssignale beider Signalwege enthält. Der nichtlineare Signalweg enthält dabei ebenfalls zwei antiparallel geschaltete Dioden.

Aus der DE-B-28 52 120 ist auch eine Korrekturschaltung für Laufzeitröhren bekannt, die einen linearen und einen nichtlinearen Signalweg enthält und bei der im nichtlinearen Signalweg zwei antiparallel geschaltete Dioden enthalten sind. Eine ähnliche Schaltung ist auch aus der US-A-3 825 843 bekannt, bei der der nichtlineare Signalweg nochmals in linearen und in f einen linearen und in einen nichtlinearen Signalweg aufgeteilt ist.

Die Aufgabe bei der vorliegenden Erfindung besteht also darin, eine Linearisierungsschaltung für HF-Leistungsverstärker der eingangs erwähnten Art zu finden, die eine hinreichend genaue Kompensation der aussteuerungsabhängigen Änderung der elektrischen Länge bei verbesserter Linearisierung des Amplitudenverhaltens der Kettenschaltung aus Linearisierungsschaltung und Leistungsverstärker ermöglicht.

Erfindungsgemäß wird die Aufgabe durch eine Linearisierungsschaltung der eingangs erwähnten Art gelöst, die durch die Merkmale entsprechend dem Kennzeichen des Patentanspruchs weitergebildet ist.

Die erfindungsgemäße Lösung bietet in vorteilhafter Weise die Möglichkeit, eine Linearisierungsschaltung unter ausschließlicher Verwendung passiver Bauteile bei insgesamt geringem Aufwand aufzubauen. In den Patentansprüchen 2 und 3 sind vorteilhafte Ausführungsformen der erfindungsgemäßen Linearisierungsschaltung näher beschrieben.

Die Erfindung soll im folgenden anhand der Zeichnung näher erläutert werden.

In der Zeichnung zeigt

Fig. 1 eine Linearisierungsschaltung nach dem Stande der Technik und

Fig. 2 die Ausführungsform einer erfindungsgemäßen Linearisierungsschaltung.

Die Fig. 1 ist bei der Erläuterung des aus der Revue Technique Thomson-CSF bekannten Standes der Technik bereits ausführlich erläutert worden, so daß an dieser Stelle nicht weiter darauf eingegangen werden soll.

Die in der Fig. 2 dargestellte Linearisierungsschaltung nach der Erfindung enthält eingangsseitig einen ersten Eingangskoppler 8, dessen einer Eingangsanschluß mit dem Eingangsanschluß E der Linearisierungsschaltung und dessen anderer Eingangsanschluß reflexionsfrei abgeschlossen ist. An den einen Ausgangsanschluß des ersten Eingangskopplers 8 schließt sich der lineare Signalweg an, der aus der Reihenschaltung eines ersten variablen Dämpfungsgliedes 9 und eines verstellbaren Phasenschiebers 10 besteht. An den anderen Ausgangsanschluß des ersten Eingangskopplers 8 schließt sich der nichtlineare Signalweg an, der mit der Reihenschaltung eines zweiten variablen Dämpfungsgliedes 11 und eines ersten als Isolator betriebenen Zirkulators 12 beginnt, dessen Ausgang mit dem einen Eingangsanschluß eines zweiten Eingangskopplers 13 verbunden ist, dessen anderer Eingangsanschluß reflexionsfrei abgeschlossen ist. Mit dem einen Ausgangsanschluß des zweiten Eingangskopplers 13 ist über die Reihenschaltung eines ersten antiparallel geschalteten Diodenpaares 14 als ersten Expander und eines dritten variablen Dämpfungsgliedes 16 ein Eingangsanschluß eines ersten Ausgangskopplers 17 verbunden. Mit dem anderen Ausgangsanschluß des zweiten Eingangskopplers 13 ist über den zweiten Expander 15, der im vorliegenden Falle aus der Reihenschaltung zweier antiparallel geschalteter Diodenpaare besteht, der zweite Eingangsanschluß des ersten Ausgangskopplers 17 verbunden. Während der erste Ausgangsanschluß dieses ersten Ausgangskopplers reflexionsfrei abgeschlossen ist, der zweite Ausgangsanschluß über einen zweiten, als Isolator betriebenen Zirkulator 18 mit einem Eingangsanschluß eines zweiten Ausgangskopplers 19 verbunden, dessen anderer Eingangsanschluß mit dem Ausgang des im linearen Signalweg angeordnetem variablen Phasenschiebers 10 verbunden ist. Während der eine Ausgangsanschluß des zweiten Ausgangskopplers 19 mit dem Ausgangsanschluß A der Linearisierungsschaltung und damit mit dem nachgeschalteten Leistungsverstärker verbunden ist, ist der andere Ausgangsanschluß des zweiten Ausgangskopplers 19 reflexionsfrei abgeschlossen.

Durch die Einstellung des Phasenschiebers 10 ist es möglich, die aussteuerungsabhängige Änderung der elektrischen Länge unter der Voraussetzung annähernd optimaler Linearisierung des Amplitudenverhaltens hinreichend genau zu kompensieren. Nimmt man diese Einstellung als fest an, so bieten die Dämpfungsglieder 9 und 11 eine erste Möglichkeit zur "groben" Einstellung des Amplitudenverhaltens, und zwar vornehmlich im Hinblick auf die zu erreichende Dämpfungsänderung des Linearisierers über dem Eingangspegel bei großer Aussteuerung.

Bei Einsatz eines zweiten Expanders 15, der parallel zum ersten Expander 14 geschaltet ist, sowie eines einstellbaren Dämpfungsgliedes 16, das zu einem dieser beiden Expander in Reihe geschaltet ist, ergibt sich zusätzlich die Möglichkeit, die Kurvenform des Aussteuerungsverhaltens im gesamten Aussteuerungsbereich so einzustellen, daß eine weitgehend optimale Annäherung an das geforderte Aussteuerungsverhalten möglich ist. Für den zweiten Expander können in Abhängigkeit vom gewünschten Amplitudenverhalten neben einem einfachen antiparallel geschalteten Diodenpaar auch Reihenschaltungen mehrerer antiparalleler Diodenpaare Verwendung finden, wobei die Expansionswirkung mit der Anzahl der Reihenschaltungen zunimmt. Eine Reihenschaltung aus zwei Diodenpaaren hat sich als besonders vorteilhaft erwiesen. Der zweite Eingangskoppler 13 ist dabei so ausgelegt, daß die Expansionswirkung des Expanders 14 vor derjenigen des Expanders 15 zum Gesamtverhalten des Linearisierers beiträgt. Die Größe des Leistungsbeitrages des Expanders 14 läßt sich dabei mit dem Dämpfungsglied 16 verändern.

## Ansprüche

1. Linearisierungsschaltung für insbesondere mittels Wanderfeldröhren aufgebaute HF-Leistungsverstärker mit einem eingangsseitigen Leistungsteiler(8) und einem ausgangsseitigen Leistungskombinator (19), die über einen linearen und einen nichtlinearen Signalweg miteinander verbunden sind und der lineare Signalweg die Reihenschaltung eines ersten Dämpfungsgliedes (9) und eines Phasenschiebers (10) und der nichtlineare Signalweg die Reihenschaltung eines als Isolator betriebenen Zirkulators (12) und eines Expanders in Form eines antiparallelen Diodenpaares enthält,
**dadurch gekennzeichnet,**
daß im nichtlinearen Signalweg zu dem antiparallelen Diodenpaar (14) als ersten Expander ein zweiter, mittels antiparallel geschalteter Dioden aufgebauter Expander (15) parallelgeschaltet ist und daß in Serie zu einem dieser beiden Expander ein Dämpfungsglied (16) geschaltet ist.

2. Linearisierungsschaltung nach Anspruch 1,
**dadurch gekennzeichnet,**
daß der zweite Expander (15) die Reihenschaltung zweier antiparallel geschalteter Diodenpaare enthält.

3. Linearisierungsschaltung nach Ansprüchen 1 oder 2,
**dadurch gekennzeichnet,**
daß an den einen Ausgang eines ersten Eingangskopplers (8) über ein zweites variables Dämpfungsglied (11) und einen ersten als Isolator betriebenen Zirkulator (12) ein zweiter Eingangskoppler (13) angeschlossen ist, dessen einer Ausgang über die Reihenschaltung eines ersten mittels eines antiparallelen Diodenpaares aufgebauten Expanders (14) und eines dritten variablen Dämpfungsgliedes (16) mit einem Eingang eines ersten Ausgangskopplers (17) verbunden ist, wobei der andere Ausgang des zweiten Eingangskopplers (13) über einen zweiten Expander (15) aus zwei antiparallelen Diodenpaaren mit einem weiteren Eingang des ersten Ausgangskopplers (17) verbunden ist, daß der Ausgang des ersten Ausgangskopplers (17) über einen zweiten, als Isolator betriebenen Zirkulator mit einem ersten Eingang eines zweiten Ausgangskopplers (19) verbunden ist und daß der zweite Ausgang des ersten Eingangskopplers (8) über die Reihenschaltung eines ersten Dämpfungsgliedes (9) und eines einstellbaren Phasenschiebers (10) mit einem zweiten Eingang des zweiten Ausgangskopplers (19) verbunden ist.

## Claims

1. Linearising circuit for RF power amplifiers, constructed, in particular, by means of travelling-wave tubes, comprising a power divider (8) at the input end and a power combiner (19) at the output end, which are connected to one another via a linear and a non-linear signal path and the linear signal path contains the series circuit of a first attenuation section (9) and of a phase shifter (10) and the non-linear signal path contains the series circuit of a circulator (12) operated as isolator and of an expander in the form of an antiparallel pair of diodes, characterized in that, in the nonlinear signal path, a second expander (15) constructed by means of antiparallel-connected diodes is connected in parallel with the antiparallel pair of diodes (14) as first expander, and in that an attenuation section (16) is connected in series with one of these two expanders.

2. Linearising circuit according to Claim 1, characterized in that the second expander (15) contains the series circuit of two antiparallel-connected pairs of diodes.

3. Linearising circuit according to Claim 1 or 2, characterized in that a second input coupler (13) is connected to one output of a first input coupler (8) via a second variable attenuation section (11) and a first circulator (12) operated as isolator, one output of which second input coupler is connected via the series circuit of a first expander (14) constructed by means of an antiparallel pair of diodes and of a third variable attenuation section (16) to one input of a first output coupler (17), the other output of the second input coupler (13) being connected via a second expander (15) of two antiparallel pairs of diodes to a further input of the first output coupler (17), in that the output of the first output coupler (17) is connected via a second circulator operated as isolator to a first input of a second output coupler (19), and in that the second output of the first input coupler (8) is connected via the series circuit of a first attenuation section (9) and of an adjustable phase shifter (10) to a second input of the second output coupler (19).

## Revendications

1. Circuit de linéarisation pour des amplificateurs de puissance à haute fréquence constitués notamment au moyen de tubes à ondes progressives et comportant un diviseur de puissance (8) situé sur le côté entrée et un combinateur de puissance (19) situé sur le côté sortie, ce diviseur et ce combinateur étant reliés entre eux par l'intermédiaire d'une voie linéaire de transmission de signaux et d'une voie non linéaire de transmission de signaux, et dans lequel la voie linéaire de transmission de signaux comporte le circuit série formé d'un premier élément d'affaiblissement (9) et d'un déphaseur (10) et la seconde voie non linéaire de transmission de signaux comporte le circuit série formé d'un circulateur (12) fonctionnant en tant qu'isolateur et d'un expanseur réalisé sous la forme d'un couple de diodes branchées selon un montage anti-parallèle, caractérisé par le fait qu'un second expanseur (15), formé au moyen de diodes branchées selon un montage en parallèle, est branché en parallèle avec le premier couple de diodes (14) branchées selon un montage antiparallèle, dans la voie non linéaire de transmission de signaux, et qu'un élément d'affaiblissement (16) est branché en série avec l'un de ces deux expanseurs.

2. Circuit de linéarisation suivant la revendication 1, caractérisé par le fait que le second expanseur (15) comporte le circuit série formé de deux couples de diodes branchées selon un montage anti-parallèle.

3. Circuit de linéarisation suivant les revendications 1 ou 2, caractérisé par la fait qu'à une sortie d'un premier coupleur d'entrée (8) est raccordé, par l'intermédiaire d'un second élément d'affaiblissement variable (11) et d'un premier circulateur (12) opérant en tant qu'isolateur, un second coupleur d'entrée (13), dont une sortie est reliée au moyen du circuit série formé d'un premier expanseur (14) constitué par un couple de diodes branchées selon un montage anti-parallèle, et d'un troisième élément d'affaiblissement variable (16), à une entrée d'un premier coupleur de sortie (17), l'autre sortie du second coupleur d'entrée (13) étant raccordée à l'autre entrée du premier coupleur de sortie (17) par l'intermédiaire d'un second expanseur (15) formé de deux couples de diodes branchées selon un montage anti-parallèle, que la sortie du premier coupleur de sortie (17) est raccordée par l'intermédiaire d'un second circulateur opérant en tant qu'isolateur, à une première entrée d'un second coupleur de sortie (19) et que la seconde sortie du premier coupleur d'entrée (8) est reliée à une seconde entrée du second coupleur de sortie (19) par l'intermédiaire du circuit série formé d'un premier élément d'affaiblissement (9) et d'un déphaseur réglable (10).

# FIG 1

# FIG 2